# EUROPEAN PATENT SPECIFICATION

(11) **EP 3 156 472 B1**
(45) Date of publication and mention of the grant of the patent: **04.12.2019**
(21) Application number: 15002954.4
(22) Date of filing: 16.10.2015
(51) Int. Cl.: C09K 11/02, C09K 11/06, H01L 51/00, H01L 51/50, H01L 51/42

(54) **NEW MEDIUM FOR TTA-PHOTON UP CONVERSION IN POLYMER HOST MATRIX**
NEUES MEDIUM ZUR TTA-PHOTON-AUFWÄRTSUMSETZUNG IN POLYMERER HOST-MATRIX
NOUVEAU MILIEU DE CONVERSION EN AMONT TTA-PHOTON EN MATRICE HÔTE POLYMÈRE

(43) Date of publication of application: 19.04.2017
(73) Proprietor: Karlsruher Institut für Technologie, 76131 Karlsruhe (DE)
(72) Inventor: Howard, Ian, 76137 Karlsruhe (DE); Richards, Bryce, 76227 Karlsruhe (DE); Turshatov, Andrey, 64347 Griesheim (DE)
(74) Representative: Müller-Boré & Partner Patentanwälte PartG mbB

(56) References cited:
- EP-A1- 2 067 839
- WO-A1-2014/136619
- US-A- 3 313 785
- US-A- 3 446 807
- US-A1- 2010 102 305
- JIANZHANG ZHAO ET AL: "Triplet-triplet annihilation based upconversion: from triplet sensitizers and triplet acceptors to upconversion quantum yields", RSC ADVANCES: AN INTERNATIONAL JOURNAL TO FURTHER THE CHEMICAL SCIENCES, vol. 1, no. 6, 5 October 2011 (2011-10-05) , page 937, XP055260263, GB ISSN: 2046-2069, DOI: 10.1039/c1ra00469g

## Description

The present invention relates to a medium for triplet-triplet annihilation up-conversion (TTA-UC), a method of triplet- triplet annihilation up-conversion, uses of said medium as well as to the use of an aliphatic polysulfone as a solid host matrix in a medium for triplet-triplet annihilation up-conversion.

In general, photon up-conversion is an optical process in which photons having low energy are transformed to photons having a higher energy inside an optical medium. The triplet-triplet annihilation up-conversion (TTA-UC) process is based on energy transfer between optically-created triplet ensembles of sensitizer molecules and accessible triplet states of emitter molecules both of which are dissolved in a liquid or in a solid matrix. Absorption of a photon and emission of a new photon with higher energy is an inherently connected chain of three steps: The first step is inter-system crossing (ISC) at the sensitizer molecules followed by the second step, namely the transfer of the excitation of the sensitizer triplet to the emitter triplet (triplet-triplet transfer, TTT). The third step is a subsequent triplet-triplet annihilation mostly between emitter molecule triplets (TTA). In summary, the up-conversion process involves the energy transfer from two lower triplet excited states to a higher singlet excited state which is then capable of emitting light with a shorter wavelength, i.e. higher energy. The TTA-UC process is a unique process since it can operate under non-coherent illumination at a relatively low concentration of <50 suns (<50 kW/m²) and achieves a quantum yield up to about 20% under such conditions.

In the past, it has been demonstrated that TTA-UC has a great potential for photovoltaic applications, the generation of solar fuels, bio-imaging and oxygen sensing. For many of these applications, the components to be used for TTA-UC have to be encapsulated into a solid host matrix such as polymers. Although this has been attempted many times, quantum yields for TTA-UC in a solid host matrix are rather low due two straightforward drawbacks. Firstly, the TTA-UC process is diffusion controlled and secondly, at the same time, the process is very sensitive to oxygen, since oxygen is a paramagnetic molecule which is one of the best quenchers of triplet states.

ISLANGULOV et al. have reported about a TTA-UC medium having a rubbery host polymer, in particular an ethylene oxide/epichlorohydrin copolymer, having a high up-converting efficiency (J. Am. Chem. Soc., 2007, 129, 12652-12653). However, said copolymer has a low glass transition temperature T_{g} of about -37 °C and thus only poor mechanical properties at ambient temperature. SINGH-RACHFORD *et al.* have further shown that when using the above ethylene oxide/epichlorohydrin copolymer blend or similar materials based on a series of thermoplastic polyurethane elastomers as a solid host matrix, cooling of the elastomer films to temperatures below the T_{g} of the respective (co)polymer completely suppresses the up-converted emission (J. Am. Chem. Soc., 2009, 131, 12007-12014).

Alternatively, MERKEL et al. have shown that a TTA-UC medium with a sensitizer and an emitter can be embedded in a polymer matrix having a high glass transition temperature Tg such as polymethylmethacrylate (J. Lumin., 2009, 129, 303-306). However, the reported quantum yield of the TTA-UC process in such a solid host matrix was extremely low (less than 0.02%). MONGUZZI *et al.* have described that up-conversion can be detected in a cellulose acetate matrix below its T_{g} of 67 °C, the quantum yield of the TTA-UC process however was reduced by three orders of magnitude when compared to the corresponding quantum yield in a THF solution (Phys. Chem. Chem. Phys., 2012, 14, 4322-4332). US 2010/0102305 describes a medium for triplet emitters in OLEDs comprising a polysulfone matrix. WO 2014/136619 describes an up-conversion light-emitting material, which optionally could comprise a polysulfone matrix.

In summary, up to now there has not been reported an efficient (i.e. with a quantum yield exceeding 1%) TTA-UC process in a polymer host matrix at a temperature T being smaller than T_{g} of the host matrix (T < T_{g}). For example, EP 13 185 751 A1 describes a rubbery polymer composition with T_{g} < 0 °C and efficient TTA-UC at room temperature (i.e. T > T_{g}). However, exploiting the rubbery polymer host matrices (where quantum efficiency is high enough) is often limited by the mechanical properties (low value of tensile modulus) of the host matrix.

Accordingly, the technical problem underlying the present invention is to provide a medium for triplet-triplet annihilation up-conversion (TTA-UC), which can be suitably used for a TTA-UC process with high quantum efficiency at ambient temperature (about 20 °C) and below the Tg of the solid host matrix of the medium, said solid host matrix of the medium having adequate mechanical characteristics at ambient temperature and providing excellent solubility for sensitizer and emitter compounds to be distributed in the matrix.

The solution to the above technical problem is achieved by the embodiments characterized in the claims.

In particular, the present invention provides a medium for triplet-triplet annihilation up-conversion (TTA-UC) comprising
a solid host matrix which comprises an aliphatic polysulfone having a structural unit of the following general formula (1) 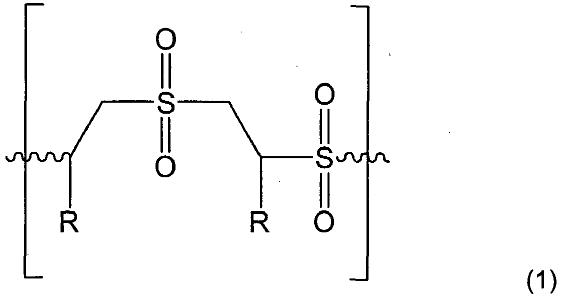 wherein each R independently represents a substituted or unsubstituted aliphatic C₄-C₂₅ hydrocarbon group;
at least one sensitizer compound which is distributed in the solid host matrix; and
at least one emitter compound which is distributed in the solid host matrix.

The medium for triplet-triplet annihilation up-conversion (TTA-UC) of the present invention comprises a solid host matrix which comprises an aliphatic polysulfone having a structural unit of the general formula (1). According to a specific embodiment, the solid host matrix consists of the aliphatic polysulfone having a structural unit of the general formula (1).

In the general formula (1), each R independently represents a substituted or unsubstituted aliphatic C₄-C₂₅ hydrocarbon group. Accordingly, some or all of the R's in general formula (1) may be different from each other, or each R may be the same.

The medium for triplet-triplet annihilation up-conversion (TTA-UC) of the present invention advantageously allows an easily detectable TTA-UC process at ambient atmospheric conditions due to the specific glassy solid host matrix comprised in the medium of the present invention having a large specific volume, said specific volume being higher in case of longer aliphatic chains R. The aliphatic chains (residues R in the general formula (1)) advantageously provide an excellent solubility of the sensitizer and emitter compounds in the host matrix, particularly in case of said compounds being dyes, and thus less aggregation of said compounds (dyes) occurs. Moreover, the large specific volume of the solid host matrix advantageously provides rotational and translation diffusion of the guest compounds. Accordingly, long-term TTA-UC performance is intrinsically achieved by arresting the oxygen diffusion and/or due to the oxygen scavenging properties of the host matrix. Moreover, the solid host matrix advantageously allows to suitably host various kinds of sensitizer compounds and emitter compounds. Due to the high glass transition temperature T_{g} of the solid host material, the medium of the present invention, besides achieving a high quantum efficiency at ambient temperature, also has adequate mechanical characteristics.

Each of the residues R in the above general formula (1) may be linear or branched. In the present invention, the term "linear" refers to a linear aliphatic hydrocarbon group such as butyl, pentyl, hexyl, etc. In the present invention, "branched" refers to a branched hydrocarbon group such as tert-butyl, *iso*-pentyl, etc. A branched residue R may provide an additional fine tuning of the thermomechanical properties of the polymer. The linear or branched aliphatic hydrocarbon group (residue R in general formula (1)) may optionally be (poly)substituted, i.e. one or more hydrogen atom(s) of the hydrocarbon group may be replaced by a substituent. Such substituents may be e.g. halogen, hydroxyl, alkoxy, carboxylic acids and derivatives thereof, acyl, amino, alkylamino, cyano, nitro, etc. Such additional substituents can advantageously provide additional functionality of the copolymers, e.g. said substituents may tune the glass transition temperature and/or provide post modification of the copolymers. According to a specific embodiment of the present invention, the at least one sensitizer compound and/or the at least one emitter compound is/are covalently linked to the polymer backbone of the solid host matrix in order to reduce dye aggregation.

Each of the residues R in the above general formula (1) may also contain one or more unsaturated bonds (double and/or triple bonds) between adjacent carbon atoms.

According to the present invention, the chain length of the aliphatic hydrocarbon group in the general formula (1) is from C₄ to C₂₅, preferably from C₁₀ to C₁₈ to provide the maximum up-conversion efficiency.

According to a particular preferred embodiment of the present invention, each R in the general formula (1) is a -C₁₄H₂₉ group, since the aliphatic polysulfone having a structural unit of the general formula (1) wherein each R is a -C₁₄H₂₉ group advantageously has a T_{g} of 50 °C, and thus, besides the advantageously high quantum efficiency of up-conversion, also has adequate mechanical characteristics comparable to those of the olefin homopolymer, a high refractive index, thermostability particularly at temperatures T < 150 - 200 °C, and excellent biocompatibility. According to a further preferred embodiment of the present invention, each R in the general formula (1) is a -C₁₀H₂₁ group.

According to the present invention, the molecular weight of the aliphatic polysulfone polymer is not particularly limited. Generally, the molecular weight should be larger than 1000 Da.

The medium for triplet-triplet annihilation up-conversion (TTA-UC) of the present invention further comprises at least one sensitizer compound and at least one emitter compound. According to the present invention, the "sensitizer compound" ("sensitizer component") is a compound/component capable of absorbing light/radiation/photons at a first wavelength λ₁, having a long-lived excite state (typically a lifetime > 500 ns), and capable of transferring energy to the "emitter compound" ("emitter component"). The emitter compound has a triplet level which quenches the long-lived excite state of the sensitizer compound and then undergoes triplet-triplet annihilation which is followed by emission of a photon with higher energy than the energy of a photon absorbed by the sensitizer. Accordingly, the emitter compound, after obtaining energy transferred from the sensitizer compound, is capable of emitting light at a second wavelength λ₂, wherein the equation λ₁ > λ₂ is fulfilled. In particular, the at least one sensitizer compound is capable of a triplet-triplet energy transfer to the at least one emitter compound, and the at least one emitter compound is capable of a triplet-triplet annihilation.

According to the present invention, the at least one sensitizer compound is not particularly limited, and thus any sensitizer compound known in the art may be comprised in the medium of the present invention. For example, any of the (sensitizer) compounds/components as described in WO 2008/110567 A1, WO 2009/071281 A1 and EP 2 851 407 A1 may be used as the at least one sensitizer compound in the medium for triplet-triplet annihilation up-conversion (TTA-UC) of the present invention. According to the present invention, the medium for triplet-triplet annihilation up-conversion may comprise only one kind of sensitizer compound, or the medium may comprise a combination of two or more different kinds of sensitizer compounds in combination. According to a preferred embodiment, the at least one sensitizer compound is palladium(ii) octaethylporphyrin ("Pd-OEP") and/or palladium(ii) meso-tetraphenyl-tetrabenzoporphyrin ("Pd-TBP").

The concentration of the at least one sensitizer compound in the medium of the present invention is not particularly limited. According to a preferred embodiment, the at least one sensitizer compound is present in a concentration of from 10⁻⁶ mol/L to 10⁻³ mol/L in the medium, particularly preferred in a concentration of from 10⁻⁵ mol/L to 10⁻⁴ mol/L. If the concentration of the at least one sensitizer compound in the medium is too low, the system may not absorb enough photons to provide efficient triplet-triplet annihilation, and thus the up-conversion quantum yield may drop down. If the concentration of the at least one sensitizer compound in the medium is too high, quenching of up-conversion by the sensitizer compound or reabsorption of emitted photons by the sensitizer compound may occur, and thus the up-conversion quantum yield may drop down.

According to the present invention, the at least one emitter compound is not particularly limited, and thus any emitter compound known in the art may be comprised in the medium of the present invention. For example, any of the (emitter) compounds/components as described in WO 2008/110567 A1, WO 2009/071281 A1 and EP 2 851 407 A1 may be used as the at least one emitter compound in the medium for triplet-triplet annihilation up-conversion (TTA-UC) of the present invention. According to the present invention, the medium for triplet-triplet annihilation up-conversion may comprise only one kind of emitter compound, or the medium may comprise a combination of two or more different kinds of emitter compounds in combination. According to a preferred embodiment, the at least one emitter compound is perylene and/or dipyrromethane.

The concentration of the at least one emitter compound in the medium of the present invention is not particularly limited. According to a preferred embodiment, the at least one emitter compound is present in a concentration of 10⁻⁵ mol/L to 0.1 mol/L in the medium, particularly preferred in a concentration of from 10⁻⁴ mol/L to 0.01 mol/L. If the concentration of the at least one emitter compound in the medium is too low, quenching of the long-lived excite state of the sensitizer compound may be insufficient. Low concentration of emitter triplet states may not provide efficient triplet-triplet annihilation, and thus the up-conversion quantum yield may drop down. If the concentration of the at least one emitter compound in the medium is too high, self-quenching of the emitter compound due to various reasons may occur, and thus the up-conversion quantum yield may drop down.

According to a preferred embodiment of the present invention, the ratio range of the amount of the at least one sensitizer compound and the at least one emitter compound is from 1:5 to 1:100, particularly preferred from 1:5 to 1:20, since in this range maximum efficiency of triplet-triplet annihilation can be expected.

According to a preferred embodiment of the present invention, the at least one sensitizer compound and the at least one emitter compound are homogeneously distributed within the solid host matrix, since homogeneous distribution advantageously provides high efficiency of the up-conversion due to avoiding aggregation of the dyes within the matrix which may lead to strong self-quenching and decrease of photoluminescent quantum yield. Such a homogeneous distribution of the at least one sensitizer compound and the at least one emitter compound in the solid host matrix can for example be realized via solution processing.

The medium for triplet-triplet annihilation up-conversion of the present invention may be produced by standard methods known to those skilled in the art. For example, the polymer host may be synthesized by standard procedures known to those skilled in the art, then the polymer host, the at least one sensitizer compound and the at least one emitter compound are dissolved in a predetermined ratio in an appropriate solvent, followed by drying of the polymer film.

According to one embodiment of the present invention, the medium further comprises an antioxidant, which may act as a sacrificial material to react with singlet oxygen produced via photosensitization by the sensitizer or emitter compound. Accordingly, the antioxidant can consume oxygen, i.e. reduce the oxygen concentration, irreversibly in the media where up-conversion occurs. The antioxidant in the present invention is not particularly limited, and thus any oxidant known in the art may be further comprised in the medium of the present invention. The medium for triplet-triplet annihilation up-conversion may comprise only one kind of antioxidant, or the medium may comprise a combination of two or more different kinds of antioxidants in combination. According to a preferred embodiment, the antioxidant is selected from the group consisting of ascorbic acid, lipoic acid, polyphenols, vitamin E.

The concentration of the antioxidant in the medium of the present invention is not particularly limited. According to a specific embodiment, the antioxidant is present in a concentration of 10⁻⁵ mol/L to 0.1 mol/L in the medium, preferably in a concentration of 10⁻⁴ mol/L to 0.01 mol/L. If the concentration of the antioxidant in the medium is too high, the antioxidant may quench the up-conversion. If the concentration of the antioxidant in the medium is too low, there may be the problem that not enough oxygen is consumed.

In a further aspect, the present invention relates to a method of triplet-triplet annihilation up-conversion (TTA-UC), comprising the steps of
providing the medium according to the present invention;
irradiating said medium with electromagnetic radiation in the wavelength range of from 450 nm to 850 nm.

In the first step of the above method, there is provided the above-described medium for triplet-triplet annihilation up-conversion of the present invention. Then, said medium is irradiated with electromagnetic radiation in the wavelength range of from 450 nm to 850 nm, which results in triplet-triplet annihilation up-conversion and the emission of light at a second wavelength which is smaller than the wavelength of irradiation. The emitted light can advantageously be detected with the naked eye.

In a further aspect, the present invention provides the use of the medium for triplet-triplet annihilation up-conversion (TTA-UC) for photovoltaic applications, for the generation of fuel cells, for bio-imaging, for oxygen sensing, for sorting material or as an anti-counterfeiting marker.

According to a particularly preferred embodiment, the medium of the present invention can be used as an (luminescent) anti-counterfeiting marker. In particular, the medium of the present invention may be incorporated into an object as a marker, which object may then be identified by a spectrophotometric analysis so as to determine the presence or absence of the marker, thereby determining whether the object is authentic or not.

According to a further particularly preferred embodiment, the medium of the present invention can be used for sorting material, especially plastic material. In particular, the medium of the present invention may be incorporated into any material, and said material may then be (automatically) separated from a mixture of various materials after the material which contains the medium of the present invention has been identified by a spectrophotometric analysis.

In a further aspect, the present invention provides the use of an aliphatic polysulfone having a structural unit of the following general formula (1) 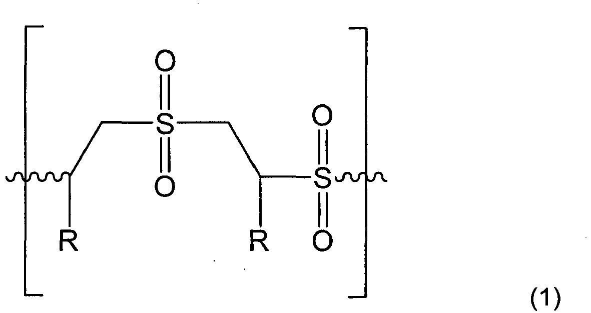 wherein each R independently represents a substituted or unsubstituted aliphatic C₄-C₂₅ hydrocarbon group
as a solid host matrix in a medium for triplet-triplet annihilation up-conversion (TTA-UC).

The aliphatic polysulfone having a structural unit of the general formula (1) for use as a solid host matrix of the present invention is the same as the aliphatic polysulfone which is comprised in the medium for triplet-triplet annihilation up-conversion (TTA-UC) of the present invention. Accordingly, the explanations provided above with respect to the aliphatic polysulfone comprised in medium of the present invention also apply for the aliphatic polysulfone for use as a solid host matrix of the present invention.

The medium for triplet-triplet annihilation up-conversion of the present invention advantageously allows an easily detectable TTA-UC process at ambient atmospheric conditions due to the specific glassy solid host matrix comprised in the medium of the present invention having a large specific volume. The aliphatic chains (residues R in the general formula (1)) advantageously provide an excellent solubility of the sensitizer and emitter compounds in the host matrix, particularly in case of said compounds being dyes, and thus less aggregation of said compounds (dyes) occurs. Moreover, the large specific volume of the solid host matrix advantageously provides rotational and translation diffusion of the host compounds. Accordingly, long-term TTA-UC performance with high quantum efficiency can advantageously be achieved. Moreover, the solid host matrix advantageously allows to suitably host various kinds of sensitizer compounds and emitter compounds. Due to the high glass transition temperature T_{g} of the solid host material, the medium of the present invention, besides achieving a high quantum efficiency at ambient temperature, also has excellent mechanical properties. In view of the above, the medium for triplet-triplet annihilation up-conversion of the present invention can suitably be used for various applications, and is particularly suitable as an anti-counterfeiting marker and for the sorting of materials.

The present invention will be further illustrated in the following examples without being limited thereto.

### Examples

### Preparation method for the following Examples 1, 2 and 3:

The polymer host was synthesized by radical copolymerization of SO₂ and hexadecane (Examples 1 and 2) or decane (Example 3) at -40 °C. The obtained polymer was dissolved in dichloromethane and precipitated by methanol. As reference material, poly(1-hexadecene-sulfone) commercially available from Sigma-Aldrich was also tested and yielded the same results.

The polymer host and the dyes listed in Examples 1, 2 and 3 were dissolved in dichloromethane and the polymer film was dried overnight under ambient conditions and afterwards under vacuum. The ratio between polymer and dyes was chosen to provide a molar concentration of the sensitizer compound to be 10⁻⁴ mol/L and a molar concentration of the emitter compound to be 0.01 mol/L.

### Example 1:

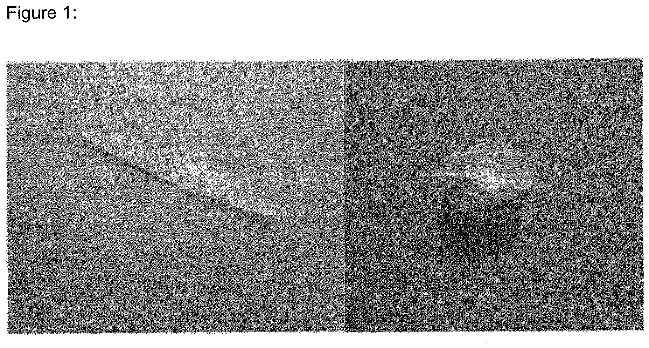

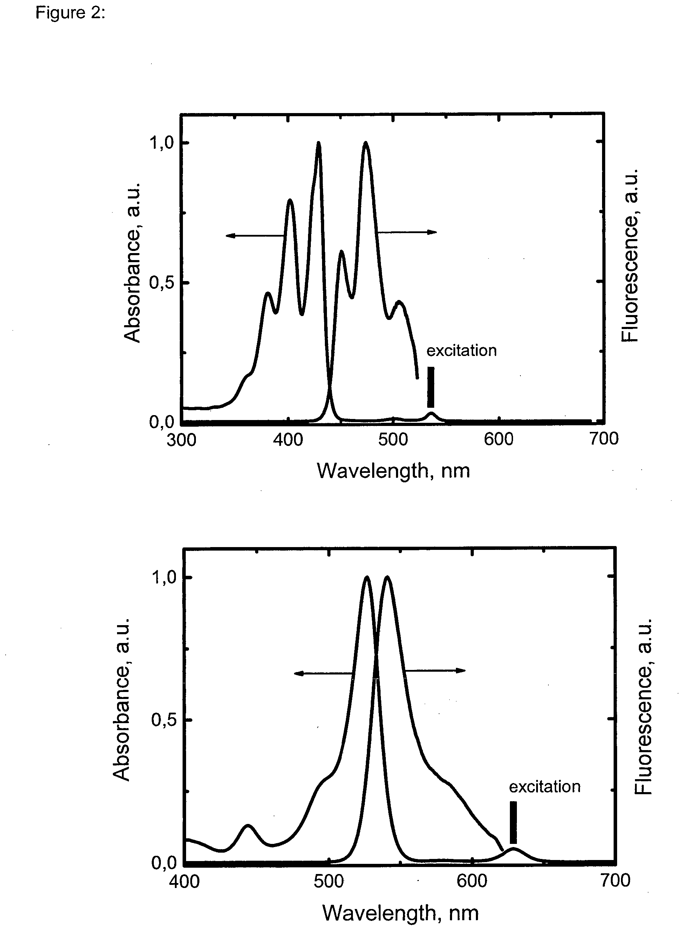

Palladium(II) octaethylporphyrin (Pd-OEP) as a sensitizer compound and perylene as an emitter compound are embedded into a poly(1-hexadecene-sulfone) film as described above. Excitation with a green laser (λ = 534 nm) results in a significant, i.e. easily detectable with the naked eye, blue luminescence (λₘₐₓ = 430 nm) (cf. Figures 1 and 2).

### Example 2:

Palladium(II) meso-tetraphenyl-tetrabenzoporphyrin (Pd-TBP) as a sensitizer compound and dipyrromethane as an emitter compound are embedded into a poly(1-hexadecene-sulfone) mold as described above. Excitation with a red laser (λ = 633 nm) results in a significant, i.e. easily detectable with the naked eye, green luminescence (λₘₐₓ = 540 nm) (cf. Figures 1 and 2).

### Example 3:

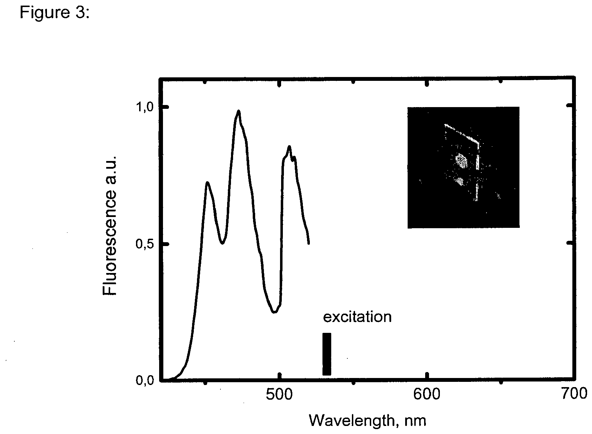

Palladium(II) octaethylporphyrin (Pd-OEP) as a sensitizer compound and perylene as an emitter compound are embedded into a poly(1-decene-sulfone) film as described above (the thin polymer film is assembled on a glass slide). Excitation with a green laser (λ = 534 nm) results in a significant, i.e. easily detectable with the naked eye, blue luminescence (λₘₐₓ = 430 nm) (cf. Figure 3).

The Figures show:
Figure 1 shows images of TTA-UC luminescence of the medium of Example 1 (left image; excitation at λ = 534 nm; detection through a short pass (cutting edge λ - 500 nm) filter) and of the medium of Example 2 (right image; excitation at λ = 635 nm; detection through a short pass (cutting edge λ - 600 nm) filter) at room temperature, i.e. T < T_{g}.
Figure 2 shows the adsorption and TTA-UC luminescence spectra of the medium of Example 1 (upper image) and of the medium of Example 2 (lower image).
Figure 3 shows the adsorption and TTA-UC luminescence spectrum of the medium of Example 3 and an insert image of TTA-UC luminescence of the medium of Example 3 (excitation at λ = 534 nm; detection through a short pass (cutting edge λ - 500 nm) filter)

## Claims

1. A medium for triplet-triplet annihilation up-conversion (TTA-UC) comprising a solid host matrix which comprises an aliphatic polysulfone having a structural unit of the following general formula (1) 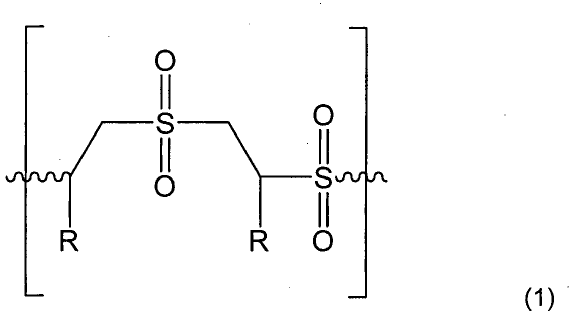 wherein each R independently represents a substituted or unsubstituted aliphatic C4-C25 hydrocarbon group;
at least one sensitizer compound which is distributed in the solid host matrix; and at least one emitter compound which is distributed in the solid host matrix.

2. The medium according to claim 1, wherein each R independently represents a substituted or unsubstituted aliphatic C₁₀-C₁₈ hydrocarbon group.

3. The medium according to claim 1 or 2, wherein each R is a -C₁₄H₂₉ group.

4. The medium according to any one of claims 1 to 3, wherein the at least one sensitizer compound is palladium(ii) octaethylporphyrin and/or palladium(ii) meso-tetraphenyl-tetrabenzoporphyrin.

5. The medium according to any one of claims 1 to 4, wherein the at least one sensitizer compound is present in a concentration of from 10⁻⁶ mol/L to 10⁻³ mol/L in the medium.

6. The medium according to any one of claims 1 to 5, wherein the at least one emitter compound is perylene and/or dipyrromethane.

7. The medium according to any one of claims 1 to 6, wherein the at least one emitter compound is present in a concentration of from 10⁻⁵ mol/L to 0.1 mol/L in the medium.

8. The medium according to any one of claims 1 to 7, wherein the at least one sensitizer compound and the at least one emitter compound are homogeneously distributed within the solid host matrix.

9. The medium according to any one of claims 1 to 8, further comprising an antioxidant.

10. The medium according to claim 9, wherein the antioxidant is present in a concentration of from 10⁻⁵ mol/L to 0.1 mol/L in the medium.

11. A method of triplet-triplet annihilation up-conversion (TTA-UC), comprising the steps of
providing a medium according to anyone of claims 1 to 10;
irradiating said medium with electromagnetic radiation in the wavelength range of from 450 nm to 850 nm.

12. Use of the medium according to any one of claims 1 to 10 for photovoltaic applications, generation of fuel cells, bio-imaging, oxygen sensing, sorting of material or as an anti-counterfeiting marker.

13. Use of an aliphatic polysulfone having a structural unit of the following general formula (1) 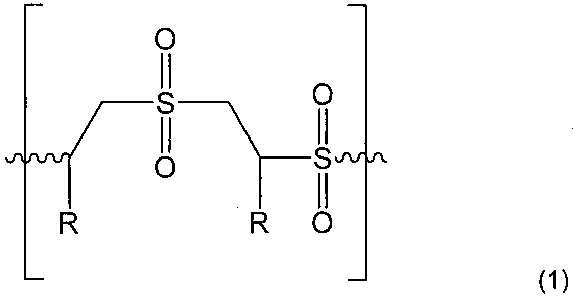 wherein each R independently represents a substituted or unsubstituted aliphatic C4-C25 hydrocarbon group
as a solid host matrix in a medium for triplet-triplet annihilation up-conversion (TTA-UC).

## Patentansprüche

1. Medium zur Triplet-Triplet-Annihilations-Aufwärtskonvertierung (TTA-UC), umfassend
eine feste Wirtsmatrix, die ein aliphatisches Polysulfon mit einer Struktureinheit der nachstehenden allgemeinen Formel (1) umfasst 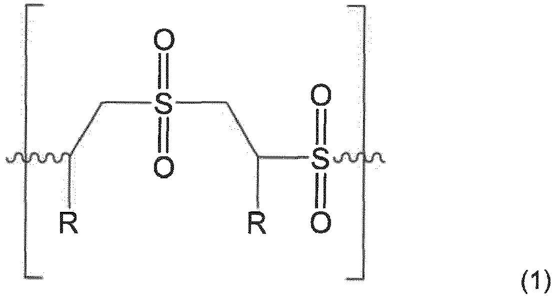 wobei jedes R unabhängig eine substituierte oder unsubstituierte aliphatische C₄-C₂₅ Kohlenwasserstoffgruppe darstellt;
mindestens eine Sensibilisatorverbindung, die in der festen Wirtsmatrix verteilt ist; und
mindestens eine Emitterverbindung, die in der festen Wirtsmatrix verteilt ist.

2. Medium nach Anspruch 1, wobei jedes R unabhängig eine substituierte oder unsubstituierte aliphatische C₁₀-C₁₈-Kohlenwasserstoffgruppe darstellt.

3. Medium nach Anspruch 1 oder 2, wobei jedes R eine -C₁₄H₂₉ Gruppe ist.

4. Medium nach einem der Ansprüche 1 bis 3, wobei die mindestens eine Sensibilisatorverbindung Palladium(ii)octaethylporphyrin und/oder Palladium(ii)mesotetraphenyltetrabenzoporphyrin ist.

5. Medium nach einem der Ansprüche 1 bis 4, wobei die mindestens eine Sensibilisatorverbindung in einer Konzentration von 10⁻⁶ mol/L bis 10⁻³ mol/L in dem Medium vorhanden ist.

6. Medium nach einem der Ansprüche 1 bis 5, wobei die mindestens eine Emitterverbindung Perylen und/oder Dipyrromethan ist.

7. Medium nach einem der Ansprüche 1 bis 6, wobei die mindestens eine Emitterverbindung in einer Konzentration von 10⁻⁵ mol/L bis 0,1 mol/L im Medium vorhanden ist.

8. Medium nach einem der Ansprüche 1 bis 7, wobei die mindestens eine Sensibilisatorverbindung und die mindestens eine Emitterverbindung innerhalb der festen Wirtsmatrix homogen verteilt sind.

9. Medium nach einem der Ansprüche 1 bis 8, weiter umfassend ein Antioxidans.

10. Medium nach Anspruch 9, wobei das Antioxidans in einer Konzentration von 10⁻⁵ mol/L bis 0,1 mol/L im Medium vorhanden ist.

11. Verfahren zur Triplet-Triplet-Annihilations-Aufwärtskonvertierung (TTA-UC), umfassend die Schritte
Bereitstellen eines Mediums nach einem der Ansprüche 1 bis 10;
Bestrahlen des Mediums mit elektromagnetischer Strahlung in dem Wellenlängenbereich von 450 nm bis 850 nm.

12. Verwendung des Mediums nach einem der Ansprüche 1 bis 10 für photovoltaische Anwendungen, Erzeugung von Brennstoffzellen, Bio-Imaging, Sauerstoffsensorik, Sortierung von Materialien oder als Fälschungsschutz-Marker.

13. Verwendung eines aliphatischen Polysulfons mit einer Struktureinheit der nachstehenden allgemeinen Formel (1) 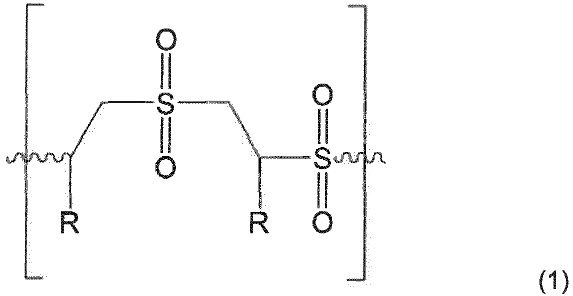 wobei jedes R unabhängig eine substituierte oder unsubstituierte aliphatische C₄-C₂₅ Kohlenwasserstoffgruppe darstellt
als eine feste Wirtsmatrix zur Triplet-Triplet-Annihilations-Aufwärtskonvertierung (TTA-UC).

## Revendications

1. Milieu de conversion ascendante par annihilation triplet-triplet (TTA-UC), comprenant une matrice hôte solide qui comprend une polysulfone aliphatique ayant une unité structurale de la formule générale (1) suivante : 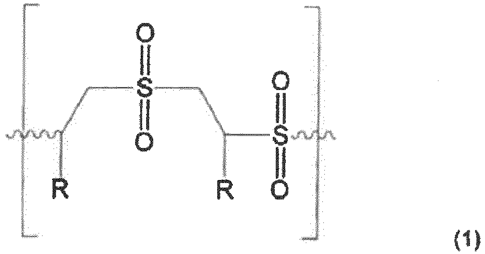 où chaque R représente indépendamment un groupe hydrocarboné aliphatique substitué ou non substitué en C₄-C₂₅ ;
au moins un composé sensibilisant qui est distribué dans la matrice hôte solide, et au moins un composé émetteur, qui est distribué dans la matrice hôte solide.

2. Milieu selon la revendication 1, où chaque R représente indépendamment un groupe hydrocarboné aliphatique substitué ou non substitué en C₁₀-C₁₈.

3. Milieu selon la revendication 1 ou 2, où chaque R est un groupe -C₁₄H₂₉.

4. Milieu selon l'une quelconque des revendications 1 à 3, où l'au moins un composé sensibilisant est l'octaéthylporphyrine de palladium (II) et/ou le méso-tétraphényl-tétrabenzoporphyrine de palladium (II).

5. Milieu selon l'une quelconque des revendications 1 à 4, où l'au moins un composé sensibilisant est présent dans le milieu en une concentration allant de 10⁻⁶ mole/litre à 10⁻³ mole/litre.

6. Milieu selon l'une quelconque des revendications 1 à 5, où l'au moins un composé émetteur est le pérylène et/ou le dipyrrométhane.

7. Milieu selon l'une quelconque des revendications 1 à 6, où l'au moins un composé émetteur est présent dans le milieu en une concentration allant de 10⁻⁵ mole/litre à 0,1 mole/litre.

8. Milieu selon l'une quelconque des revendications 1 à 7, où l'au moins un composé sensibilisant et l'au moins un composé émetteur sont distribués de manière homogène dans la matrice hôte solide.

9. Milieu selon l'une quelconque des revendications 1 à 8, comprenant en outre, un antioxydant.

10. Milieu selon la revendication 9, où l'antioxydant est présent dans le milieu en une concentration allant de 10⁻⁵ mole/litre à 0,1 mole/litre.

11. Procédé de conversion ascendante par annihilation triplet-triplet (TTA-UC), comprenant les étapes de
fourniture d'un milieu selon l'une quelconque des revendications 1 à 10 ; irradiation dudit milieu au moyen d'un rayonnement électromagnétique dans la plage de longueurs d'onde allant de 450 nm à 850 nm.

12. Utilisation du milieu selon l'une quelconque des revendications 1 à 10 pour des applications photovoltaïques, la génération de cellules combustibles, la bio-imagerie, la détection d'oxygène, le tri de matériau ou comme marqueur anti-contrefaçon.

13. Utilisation d'une polysulfone aliphatique ayant une unité structurale de la formule générale (1) suivante : 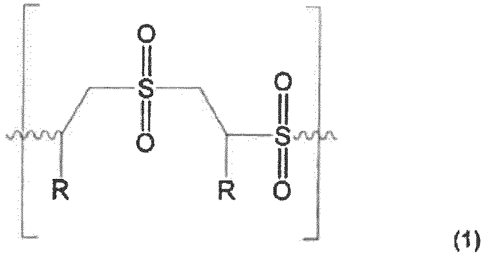 où chaque R représente indépendamment un groupe hydrocarboné aliphatique substitué ou non substitué en C₄-C₂₅
comme matrice hôte solide d'un milieu de conversion ascendante par annihilation triplet-triplet (TTA-UC).
